Europäisches Patentamt

European Patent Office

Office européen des brevets

(11) Veröffentlichungsnummer: **0 003 808**
A1

(12) # EUROPÄISCHE PATENTANMELDUNG

(21) Anmeldenummer: 79100453.4

(22) Anmeldetag: 15.02.79

(51) Int. Cl.²: **H 03 F 3/19**
H 03 F 3/50, H 04 B 3/36

(30) Priorität: 16.02.78 DE 2806704

(43) Veröffentlichungstag der Anmeldung:
05.09.79 Patentblatt 79/18

(84) Benannte Vertragsstaaten:
BE CH DE FR GB IT NL SE

(71) Anmelder: SIEMENS AKTIENGESELLSCHAFT Berlin
und München
Postfach 261
D-8000 München 22(DE)

(72) Erfinder: Birth, Winfrid
St. Veit-Strasse 70
D-8000 München 80(DE)

(54) Breitbandverstärker mit einer ersten und einer zweiten Transistorstufe.

(57) Breitbandverstärker mit zwei Transistorstufen. Damit die von der ersten Stufe abzugebende Steuerspannung möglichst niedrig sei, sind die Emitter- Kollektorstrecke des ersten Transistors (31) und die Basis - Emitter-Strecke des zweiten Transistors (32) wechselspannungsmässig parallelgeschaltet. In den wechselspannungsmässigen Parallelverbindungen ist mindestens eine galvanische Trennstelle vorgesehen.

Der Verstärker kann insbesondere als Leitungsverstärker der Trägerfrequenztechnik Verwendung finden.

FIG 3

EP 0 003 808 A1

0003808

SIEMENS AKTIENGESELLSCHAFT          Unser Zeichen
Berlin und München                  VPA 78 P 6 5 3 2 BRD

Breitbandverstärker mit einer ersten und einer zweiten
Transistorstufe

Die Erfindung bezieht sich auf einen Breitbandverstärker,
vorzugsweise Leitungsverstärker der Trägerfrequenztechnik, mit einer einen ersten Transistor enthaltenden
ersten Transistorstufe und einer einen zweiten Transistor vom gleichen oder entgegengesetzten Leitfähigkeitstyp enthaltenden zweiten Transistorstufe, bei der
in der Emitterzuleitung des Transistors eine Impedanz
angeordnet ist.

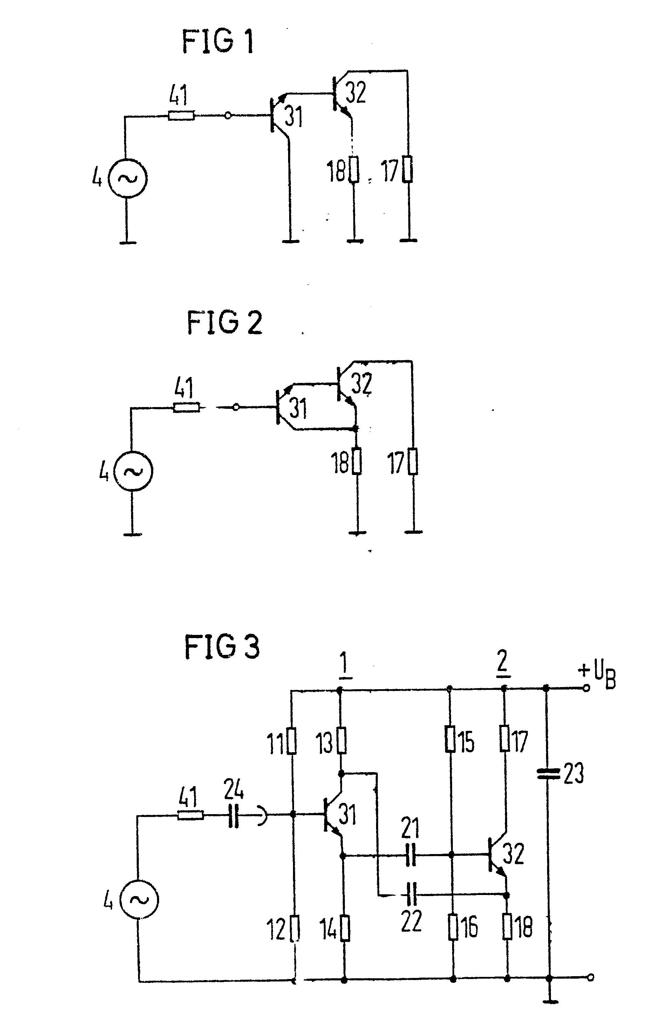

Ein HF-Prinzipschaltbild eines Breitbandverstärkers in
Kollektor-Emitterschaltung mit Reihengegenkopplung ist
in Fig.1 gezeigt. Der Emitterwiderstand 18 bewirkt
Reihengegenkopplung über beide Stufen.

Ein derartiger zweistufiger Verstärker hat den Nachteil,
daß die vom ersten in der Treiberstufe enthaltenen Transistor 31 abzugebende Steuerspannung mit wachsendem
Emitterwiderstand 18 des zweiten Transistors 32 an-

Wd 1 Bri / 14.2.1978

steigt.

Es ist bereits ein Transistorschalter bekannt
(DE-AS 1 158 562), bei dem parallel zur Basis-Emitter-
Strecke des einen Transistors die Emitter-Kollektor-
Strecke des anderen Transistors angeordnet ist. Dieser
aus zwei komplementären Transistoren zusammengesetzte
Transistorschalter ist durch ein Eingangssignal einer
bestimmten Polarität durchlässig und bei einem Eingangssignal entgegengesetzter Polarität sperrend. Der eine
Transistor dient dazu, den Kollektor-Reststrom im
Sperrzustand des anderen abzuleiten, der als Transistorverstärker dient. Die Schaltung ist nicht als linearer Verstärker zu gebrauchen.

Aufgabe der Erfindung ist es, einen Breitbandverstärker
der vorstehend näher bezeichneter Art derart auszubilden, daß ein HF-Breitbandsignal so verstärkt wird, daß
das Verstärkungs-Klirrdämpfungs-Produkt hoch ist und
dabei die Treiberstufe eine möglichst niedrige Steuerspannung abzugeben braucht.

Gemäß der Erfindung wird der Breitbandverstärker zur
Lösung dieser Aufgabe derart ausgebildet, daß die Basis-Emitter-Strecke des zweiten Transistors der Emit-
ter-Kollektor-Strecke des ersten Transistors unter Umgehung der Impedanz, insbesondere direkt, wechselspannungsmäßig parallelgeschaltet ist, und daß in der wechselspannungsmäßigen Parallelschaltung wenigstens eine
galvanische Trennstelle vorgesehen ist.

Durch diese Maßnahmen ergibt sich ein Breitbandverstärker mit einem besonders großen Verstärkungs-Klirrdämp-
fungs-Produkt.

Weitere vorteilhafte Ausgestaltungen der Erfindung ergeben sich aus den Unteransprüchen.

Die Erfindung wird anhand der in den Fig.2 und 3 gezeigten Ausführungsbeispiele näher erläutert.

Es zeigen:

Fig.1 ein HF-Ersatzschaltbild einer bekannten Kollektor-Emitter-Schaltung mit Reihengegenkopplung über beide Stufen,

Fig.2 ein HF-Ersatzschaltbild und

Fig.3 den Stromlauf eines zweistufigen Verstärkers nach der Erfindung.

Bei dem in Fig.1 gezeigten bekannten Verstärker sind eine Kollektorstufe und eine Emitterstufe in Kette geschaltet. An die Emitter-Kollektor-Strecke des ersten, in Kollektorschaltung geschalteten Transistors 31 ist eine Serienschaltung, bestehend aus der Basis-Emitter-Strecke des zweiten Transistors 32 und dem in der Emitterzuleitung dieses Transistors liegenden Widerstand 18 angeschlossen. Je größer der Wert des Widerstandes 18 ist, umso größer muß die vom Transistor 31 abgegebene Steuerspannung sein, um ein stets gleich großes Ausgangssignal an den Widerständen 17 oder 18 zu erreichen.

Fig.2 zeigt ein HF-Ersatzschaltbild eines zweistufigen Verstärkers mit Reihengegenkopplung über beide Stufen und besonders geringer Spannungsaussteuerung der ersten Stufe. Die Basis-Emitter-Strecke des Transistors 32 ist wechselspannungsmäßig unmittelbar an die Emitter-Kollektor-Strecke des vorgeschalteten Transistors 31 angeschlossen. Der Widerstand 18 liegt zwischen der Emitter-

Kollektor-Verbindung der Transistoren 32 und 31 einerseits und Bezugspotential andererseits.

In dem Breitbandverstärker nach Fig.2 ist die von der ersten Transistorstufe 1 abgebende Kollektor-Emitter-Spannung bei etwa unveränderter Stromansteuerung der zweiten Transistorstufe um den Faktor $1 + S_{32}R18$ geringer als in der Schaltung nach Fig.1, wobei mit $S_{32}$ die Steilheit des Transistors 32 und mit R18 der Wert des Widerstandes 18 bezeichnet sind. Damit sind auch die durch Spannungsaussteuerung der Vorstufe verursachten nichtlinearen Verzerrungen geringer.

Die Verstärker nach Fig.1 und 2 zeigen bei tiefen Frequenzen etwa gleiche Außenverstärkung. In einem höheren Frequenzbereich, z.B. von etwa 40 bis 80 MHz, liegt die Verstärkung des in Fig.2 gezeigten Verstärkers wesentlich höher. Ferner sind die Übertragungsfaktoren der internen Gegenkopplungsschleifen und folglich auch die Eingangsimpedanzen der ersten Stufe in beiden Fällen unterschiedlich.

Alle genannten Einflüsse führen dazu, daß das Verstärkungs-Klirrdämpfungs-Produkt für den Verstärker nach Fig.2 wesentlich höher ist.

Der in Fig.3 gezeigte Stromlauf zeigt weitere Einzelheiten des Breitbandverstärkers nach Fig.2. Der Transistor 31 der ersten Transistorstufe 1 ist mit seiner Basis an den Spannungsteiler 11, 12 angeschlossen, mit dem Kollektor über den Widerstand 13 an Versorgungsspannung $+U_B$ und mit dem Emitter über den Widerstand 14 an Bezugspotential oder Masse geführt. Zwischen der Basis des Transistors 31 und dem Bezugspotential liegt die Wechsel-Spannungsquelle 4, deren Innenwiderstand mit 41 bezeichnet ist, und die über den Blockkondensator 24 an die Basis des Transistors 31 geführt ist.

Der Basisspannungsteiler 11, 12 kann z.B. dann entfallen, wenn der Transistor 31 seine Basisvorspannung auf andere Weise, z.B. von einer vorausgehenden Verstärkerstufe her, erhält.

Der Transistor 32 der zweiten Transistorstufe 2 ist mit seiner Basis sowohl an den Spannungsteiler 15, 16 angeschlossen, als auch über den Kondensator 21 mit dem Emitter des Transistors 31 verbunden. Der Transistor 32 ist ferner mit dem Kollektor über den Widerstand 17 an die Versorgungsspannung $+U_B$ und mit dem Emitter über die Impedanz bzw. den Widerstand 18 an Bezugspotential geführt. Die in der Emitterzuführung des zweiten Transistors 32 gelegene Impedanz 18 ist nicht vernachlässigbar klein.

Zwischen dem Kollektor des Transistors 31 und dem Emitter des Transistors 32 liegt der Kondensator 22. Die Quelle für die Versorgungsspannung $+U_B$ ist durch den Kondensator 23 wechselspannungsmäßig überbrückt.

Die Kondensatoren 21 bis 23 sind so bemessen, daß sie für das zu verstärkende HF-Signal durchlässig sind. Als Emitterwiderstand des Transistors 32, d.h. als Widerstand zwischen dem Emitter des Transistors 32 und Bezugspotential ist daher die Parallelschaltung der Widerstände 13 und 18 wirksam. Den Lastwiderstand für die zweite Transistorstufe 2 bilden die Widerstände 17 und 18. Die Aufteilung des Lastwiderstandes auf diese beiden Widerstände 17 und 18 ist je nach Art der Endstufe verschieden und hängt insbesondere davon ab, ob die Endstufe als Kollektor- oder Emitterstufe ausgebildet ist.

Die Widerstände 14 und 18 bestimmen die Ruheströme der Transistoren 31 und 32. Zweckmäßigerweise kann man einen Teil des Widerstandes 14 und/oder 18 kapazitiv bzw. hochfrequenzmäßig überbrücken, so daß sich für Gleich- und Wechselstrom unterschiedliche Emitterwiderstände ergeben.

In Abwandlung des Verstärkers nach Fig.3 kann es zweckmäßig sein, den Kondensator 21 durch eine galvanische Verbindung zu ersetzen und die Widerstände 15 und 16 wegzulassen. Falls die Transistoren von unterschiedlichem Leitfähigkeitstyp sind, muß die Versorgungsspannung an einem Transistor umgepolt werden. Es besteht dann die Möglichkeit, den Kondensator 22 unter Beibehaltung des Kondensators 21 und der Widerstände 15 und 16 durch eine galvanische Verbindung zu ersetzen.

Je nach Bemessung des Verstärkers ist die zweite Transistorstufe 2 eine Emitter- oder Kollektorstufe.

Bei der Bemessung des Verstärkers im Hinblick auf eine Kollektor-Endstufe ist der Wert des Widerstandes 13 wesentlich größer als der des Widerstandes 18, der die Nutzlast darstellt. Der Wert des Widerstandes 17 ist Null oder sehr klein. Der Wert des Widerstandes 18 ist vorzugsweise etwa gleich dem Quotienten aus der Kollektor-Emitter-Spannung und dem Kollektorstrom des Transistors 32.

Bei der Bemessung als Verstärker mit Emitterendstufe sind die Werte der Widerstände 13 und 18, insbesondere etwa gleich groß. Der Wert des Widerstandes 17, der nun die Nutzlast bildet, ist wesentlich größer als der Wert des Widerstandes 18 und entspricht seinerseits etwa dem Quotienten aus Kollektor-Emitterspannung und dem Kollektorstrom des Transistors 32.

Der zwischen dem Emitter des Transistors 32 und dem Kollektor des Transistors 31 liegende Kondensator 22 kann durch einen Zweipol ersetzt werden, der als gleichstromundurchlässiger komplexer Widerstand ausgebildet ist und wenigstens einen ohmschen Widerstand und/oder wenigstens eine Induktivität enthält. Dabei können anstelle einer kapazitiven Verbindung mehrere derartige komplexe Widerstände parallelgeschaltet sein.

Auf diese Weise läßt sich auf vorteilhafte Weise eine Korrektur des Frequenzganges erzielen.

Da sich der HF-Weg im Eingangskreis des Transistors 32 unmittelbar über die Emitter-Kollektor-Strecke des Transistors 31 schließt, bleiben Änderungen des Widerstandes 18 ohne Einfluß auf den Eingangskreis. Der Verstärker eignet sich daher besonders für Anwendungen, bei denen der Widerstand 18 ein zum Abgleich der Reihengegenkopplung veränderbarer komplexer Widerstand ist.

6 Patentansprüche
3 Figuren

0003808

Patentansprüche

1. Breitbandverstärker, vorzugsweise Leitungsverstärker der Trägerfrequenztechnik, mit einer einen ersten Transistor enthaltenden ersten Transistorstufe und einer einen zweiten Transistor vom gleichen oder entgegengesetzten Leitfähigkeitstyp enthaltenden zweiten Transistorstufe, bei der in der Emitterzuleitung des Transistors eine Impedanz angeordnet ist, d a d u r c h g e k e n n z e i c h n e t , daß die Basis-Emitter-Strecke des zweiten Transistors (32) der Emitter-Kollektor-Strecke des ersten Transistors (31) unter Umgehung der Impedanz (18), insbesondere direkt, wechselspannungsmäßig parallelgeschaltet ist, und daß in der wechselspannungsmäßigen Parallelschaltung wenigstens eine galvanische Trennstelle vorgesehen ist.

2. Breitbandverstärker nach Anspruch 1, d a d u r c h g e k e n n z e i c h n e t , daß der zweite Transistor (32) von gleichem Leitfähigkeitstyp mit seiner Basis galvanisch an den Emitter und mit seinem Emitter über einen Kondensator (22) unmittelbar an den Kollektor des ersten Transistors (31) geführt ist.

3. Breitbandverstärker nach Anspruch 1, d a d u r c h g e k e n n z e i c h n e t , daß der zweite Transistor (32) vom entgegengesetzten Leitfähigkeitstyp mit seiner Basis an eine Einrichtung zur Basisspannungsversorgung und über einen Kondensator (21) an den Emitter und mit seinem Emitter galvanisch an den Kollektor des ersten Transistors (31) geführt ist.

4. Breitbandverstärker nach einem der Ansprüche 1 bis 3, d a d u r c h g e k e n n z e i c h n e t , daß der zweite Transistor (32) mit seiner Basis an eine Einrichtung zur Basisspannungsversorgung und über einen ersten Kondensator (21) an den Emitter und mit seinem
Emitter über einen zweiten Kondensator (22) an den
Kollektor des ersten Transistors (31) angeschlossen ist.

5. Breitbandverstärker nach einem der Ansprüche 1 bis 4,
d a d u r c h   g e k e n n z e i c h n e t ,   daß
in wenigstens einer der zwischen den Transistoren (31,32)
vorgesehenen kapazitiven Verbindungen wenigstens einen
ohmschen Widerstand und/oder wenigstens eine Induktivität enthält.

6. Breitbandverstärker nach einem der Ansprüche 1
bis 5, d a d u r c h   g e k e n n z e i c h n e t ,
daß die Ausgangsnutzlast im Kollektorweg und/oder im
Emitterweg des zweiten Transistors (32) liegt.

FIG 1

FIG 2

FIG 3

0003808

Europäisches Patentamt

**EUROPÄISCHER RECHERCHENBERICHT**

Nummer der Anmeldung
EP 79 10 0453

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | **FR - A - 1 127 772** (THOMSON-HOUSTON) <br><br> * Seite 2, linke Spalte, letzter Absatz; rechte Spalte, Zeilen 1-26; Figur 4 * <br><br> -- | 1,2,6 |
| X | TOUTE L'ELECTRONIQUE, Vol. 37, Nr. 351, Dezember 1970, Paris, FR, SYMONS: "Circuits d'amplification à contre-réaction ou "Bootstrap Circuits", Seiten 545-551 <br><br> * Figur 14; Seite 548, linke Spalte * <br><br> -- | 1,2,6 |
| | JOURNAL OF SCIENTIFIC INSTRUMENTS, Vol. 43, Nr. 10, Oktober 1966, London, GB, HULLEY et al. : "High input impedance circuits for the measurement of bioelectric potentials", Seiten 728-734 <br><br> * Seite 729, Absatz 3, Zeile 1; Figur 4 * <br><br> -- | 1,2,6 |
| | **US - A - 2 881 269** (HANEL et al) <br><br> * Figur 1; Spalte 1, Zeile 54 - Spalte 2, Zeile 20 * <br><br> -- | 1,2,6 |
| | **FR - A - 1 084 604** (PHILIPS) <br><br> * Seite 1, rechte Spalte, letzter Absatz - Seite 2, linke Spalte, Absatz 1; Figur 1 * <br><br> ---- | 1,3,6 |

**KLASSIFIKATION DER ANMELDUNG (Int.Cl.²)**

H 03 F 3/19
        3/50
H 04 B 3/36

**RECHERCHIERTE SACHGEBIETE (Int. Cl.²)**

H 03 F 3/19
        3/50
        1/42
        1/48
H 04 B 3/36

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 23-05-1979 | THOMAES |

EPA form 1503.1  06.78